# EUROPÄISCHE PATENTANMELDUNG

(11) **EP 4 704 302 A1**
(43) Veröffentlichungstag der Anmeldung: **04.03.2026**
(21) Anmeldenummer: 24196901.3
(22) Anmeldetag: 28.08.2024
(51) Int. Cl.: H02J 50/00, H02J 50/10, H02J 50/70

(54) **LEITERPLATTENVORRICHTUNG UND VORRICHTUNG AUFWEISEND EINE LEITERPLATTENVORRICHTUNG**

(71) Anmelder: Siemens Aktiengesellschaft, 80333 München (DE)
(72) Erfinder: Mayer, Lukas Walter, 1190 Wien (AT); Müller, Bernd, 16259 Falkenberg (DE); Pitschko, Benedikt, 1100 Wien (AT); Resel, Leopold, 1030 Wien (AT); Frühauf, Peter, 14612 Falkensee (DE); Klöpzig, Markus, 91320 Ebermannstadt (DE)
(74) Vertreter: Siemens Patent Attorneys

(57) **Zusammenfassung**

Die Erfindung betrifft eine Leiterplattenvorrichtung (10), wobei die Leiterplattenvorrichtung (10) zwei Leiterplatteneinrichtungen (12, 14) aufweist, die durch einen Trennspalt (16 voneinander getrennt sind, wobei die Leiterplatteneinrichtungen (12, 14) jeweilige Magnetkerneinrichtung (24, 26) aufweisen. Die Leiterplattenvorrichtung (10) weist eine Federeinrichtung (18) auf die dazu eingerichtet ist, die erste Leiterplatteneinrichtung (12) entlang einer Hauptrichtung (20) gegen die zweite Leiterplatteneinrichtung (14) verschiebbar zu lagern und bei einer Auslenkung der ersten Leiterplatteneinrichtung (12) aus einer Grundstellung (22), die erste Leiterplatteneinrichtung (12) mit einer von der Auslenkung abhängigen Rückstellkraft zu beaufschlagen, sodass die zwei Leiterplatteneinrichtungen (12, 14) ein Schwingungssystemsystem bilden, dass ein vorgegebenes Resonanzverhalten aufweist. Es ist vorgesehen, dass durch eine Schwingung der ersten Leiterplatteneinrichtung (12) gegen die zweite Leiterplatteneinrichtung (14) Spaltabstände (52, 54) zwischen den Magnetkerneinrichtungen (24, 26) an den Luftspalten (48, 50) variieren, sodass eine Magnetflussdichte des Hauptmagnetflusses (32) durch die Spuleneinrichtung (30) variiert und in der Spuleneinrichtung (30) ein elektrischer Strom induziert wird.

## Beschreibung

Die Erfindung betrifft eine Leiterplattenvorrichtung sowie eine Vorrichtung, die eine Leiterplattenvorrichtung aufweist.

Drahtlose Sensorik wird in vielen Anwendungsbereichen, wie zum Beispiel in der Industrie oder im Transportwesen, immer wichtiger. Die Energieversorgung stellt für solche drahtlosen Sensoren eine große Herausforderung dar, und die Brauchbarkeit von Sensorsystemen ist sehr oft nur durch eine autonome Energieversorgung der Sensoren gegeben. Sensoren sollen über einen langen Zeitraum ohne großen Wartungsaufwand funktionieren. Damit dies realisierbar wird, müssen nicht nur die elektronischen Komponenten, welche die verbauten Bauteile auf der Leiterplatte umfassen können, für geringen Energieverbrauch ausgewählt werden, sondern auch die Energieversorgung hinsichtlich ihrer Langlebigkeit und Zuverlässigkeit selektiert werden. Momentan dienen Batterien oder Akkus als Hauptenergielieferanten in verteilten Sensorsystemen. Jedoch haben Akkumulatoren und Batterien den Nachteil, dass sie nur für eine begrenzte Zeit die notwendige Energie liefern können.

Des Weiteren kann es, je nach Einsatzzweck und -ort der Sensoren, zu einem zeit- und kostenintensiven Wartungs- und Tauschaufwand kommen. Beispielsweise muss ein Servicemitarbeiter in gewissen Serviceintervallen vor Ort die Sensoren warten. Diese Intervalle können durch ein intelligentes Design und die Nutzung zusätzlicher Energiequellen verlängert oder sogar eliminiert werden. Aus diesem Grund werden neue Energiequellen für den autonomen Einsatz notwendig.

Als Energiequelle können beispielsweise sogenannte Energy Harvester verwendet werden. Das sogenannte Energy Harvesting umfasst verschiedene Formen der Energiegewinnung aus der Umgebung, wie beispielsweise aus Vibration, Lichteinstrahlung oder einem Temperaturunterschied zwischen zwei oder mehreren Elementen. Die physikalischen Eigenschaften können durch unterschiedlichste Prinzipien genutzt werden, die auf dem piezoelektrischen, elektromagnetischen, thermodynamischen oder photoelektrischen Effekt basieren. Die bestehenden Energy Harvester sind bis zu einem gewissen Grad verwendbar, unterliegen jedoch Einschränkungen und benötigen neben der für die Sensoren notwendigen Flachbaugruppe zusätzlichen Hardware-, Installations- und Verdrahtungsaufwand.

Die Anforderungen an ein Energy Harvester umfassen, dass dieser genügend Energie für einen Betrieb einer zu versorgenden Vorrichtung zur Verfügung stellt. Der Energy Harvester muss hoch effizient, leicht in eine Einsatzumgebung integrierbar, und robust gegenüber Umwelteinflüssen und langlebig sein.

Es ist eine Aufgabe der vorliegenden Erfindung, eine Harvestereinrichtung bereitzustellen, welche die genannten Erfordernisse erfüllt.

Diese Aufgabe wird gelöst durch den jeweiligen Gegenstand der unabhängigen Ansprüche. Vorteilhafte Weiterbildungen und bevorzugte Ausführungsformen sind Gegenstand der abhängigen Ansprüche.

Ein erster Aspekt der Erfindung betrifft eine Leiterplattenvorrichtung. Die Leiterplattenvorrichtung weist zwei parallel in einer Hauptebene angeordnete Leiterplatteneinrichtungen auf, die durch einen Trennspalt in der Hauptebene voneinander getrennt sind. Mit anderen Worten weist die Leiterplattenvorrichtung die Hauptebene auf, in welcher die zwei Leiterplatteneinrichtungen der Leiterplattenvorrichtung angeordnet sind. Zwischen den Leiterplatteneinrichtungen befindet sich der Trennspalt, wodurch die Leiterplatteneinrichtungen voneinander beabstandet sind. Die zwei Leiterplatteneinrichtungen können beispielsweise durch ein Ausfräsen des Trennspaltes aus einer ursprünglichen Leiterplatte getrennt sein.

Die Leiterplatteneinrichtungen weisen jeweils eine Magnetkerneinrichtung auf, die dazu eingerichtet ist, einen Hauptmagnetfluss durch eine Magneteinrichtung der ersten oder einer der zweiten Leiterplatteneinrichtungen und eine Spuleneinrichtung einer der zweiten Leiterplatteneinrichtungen zu führen. Der Hauptmagnetfluss wird dabei über Luftspalte in dem Trennspalt geführt. Mit anderen Worten weist jede der Leiterplatteneinrichtungen die jeweilige Magnetkerneinrichtung auf, welche als Magnetflussleiteinrichtung vorgesehen ist. Die erste Leiterplatteneinrichtung weist eine Magneteinrichtung auf, welche dazu eingerichtet ist, ein Magnetfeld bereitzustellen. Die Magneteinrichtung kann eine oder mehrere Permanentmagneteinheiten umfassen. Die zweite der Leiterplatteneinrichtungen weist eine Spuleneinrichtung auf. Die Magnetkerneinrichtung der ersten Leiterplatteneinrichtung ist dazu eingerichtet, den Hauptmagnetfluss durch die Magneteinrichtung zu leiten. Mit anderen Worten ist die Magnetkerneinrichtung der ersten Leiterplatteneinrichtung dazu eingerichtet, den von der Magneteinrichtung abfließenden Hauptmagnetfluss von der Magneteinrichtung abzuführen und den der Magneteinrichtung zufließenden Hauptmagnetfluss zu der Magneteinrichtung zu führen.

Die Magnetkerneinrichtung der zweiten der Leiterplatteneinrichtungen ist dazu eingerichtet, den Hauptmagnetfluss durch die Spuleneinrichtung zu leiten. Mit anderen Worten ist die Magnetkerneinrichtung der ersten Leiterplatteneinrichtung dazu eingerichtet, den der Magneteinrichtung zufließenden Hauptmagnetfluss zu der Spuleneinrichtung zu führen und den von der Spuleneinrichtung abfließenden Hauptmagnetfluss von der Spuleneinrichtung abzuführen.

Der Hauptmagnetfluss wird von der Magnetkerneinrichtung der ersten Leiterplatteneinrichtung an einem Luftspalt, der sich in dem Trennspalt befindet, über den Trennspalt in die Magnetkerneinrichtung der zweiten Leiterplatteneinrichtung geführt. Der Hauptmagnetfluss wird von der Magnetkerneinrichtung der zweiten Leiterplatteneinrichtung über einen weiteren Luftspalt in dem Trennspalt in der Magnetkerneinrichtung der ersten Leiterplatteneinrichtung geführt. Die Magnetkerneinrichtungen können an den Luftspalten Spaltkanten aufweisen, die sich gegenüberliegen können. Mit anderen Worten sind die Magnetkerneinrichtungen am Trennspalt durch die Luftspalte voneinander getrennt. Die Luftspalte können beispielsweise Bereiche zwischen gegenüberliegenden Spaltkanten der Magnetkerneinrichtungen im Trennspalt bezeichnen.

Die Leiterplattenvorrichtung weist eine Federeinrichtung auf, die dazu eingerichtet ist, die erste Leiterplatteneinrichtung entlang einer Hauptrichtung gegen die zweite Leiterplatteneinrichtung verschiebbar zu lagern und bei einer Auslenkung der ersten Leiterplatteneinrichtung aus einer Grundstellung bezüglich der zweiten Leiterplatteneinrichtung, die erste Leiterplatteneinrichtung mit einer von Rückstellkraft zu beaufschlagen, die von der Auslenkung entlang der Hauptrichtung abhängt. Durch die Federeinrichtung bilden die zwei Leiterplatteneinrichtungen ein mechanisches Schwingungssystem, das ein vorgegebenes Resonanzverhalten aufweist. Mit anderen Worten ist die Federeinrichtung dazu eingerichtet, die erste Leiterplatteneinrichtung in einer Grundstellung gegenüber der zweiten Leiterplatteneinrichtung zu lagern. Die Federeinrichtung ist dazu eingerichtet, die Leiterplatteneinrichtungen derart zueinander zu lagern, dass eine Verschiebung der ersten Leiterplatteneinrichtung gegenüber der zweiten Leiterplatteneinrichtung entlang der Hauptrichtung möglich ist. Die Federeinrichtung ist dazu eingerichtet, bei einer Auslenkung der ersten Leiterplatteneinrichtung aus der Grundstellung, die erste Leiterplatte mit der Rückstellkraft zu beaufschlagen, welche in Richtung der Grundstellung wirkt. Durch die Bereitstellung der Federeinrichtung ist es möglich, dass die erste Leiterplatteneinrichtung bezüglich der zweiten Leiterplatteneinrichtung entlang der Hauptrichtung bei einer Anregung schwingen kann.

Es ist vorgesehen, dass durch die Schwingung der ersten Leiterplatteneinrichtung gegen die zweite Leiterplatteneinrichtung die Spaltabstände zwischen den Magnetkerneinrichtungen an den Luftspalten variieren. Durch die Varianz der Spaltabstände verändert sich eine Magnetflussdichte des Hauptmagnetflusses durch die Spuleneinrichtung. Durch die Änderung der Magnetflussdichte wird in der Spuleneinrichtung elektrischer Strom induziert. Mit anderen Worten ist es vorgesehen, dass durch die Auslenkung der ersten Leiterplatteneinrichtung aus der Grundstellung Spaltabstände zwischen den Magnetkerneinrichtungen an den Luftspalten verändert werden. Ein magnetischer Widerstand an dem jeweiligen Luftspalt hängt von dem Spaltabstand des jeweiligen Luftspalts ab, sodass die Veränderung des Spaltabstands eine Veränderung des magnetischen Widerstands an dem betreffenden Luftspalt bewirkt. Dadurch, dass der Hauptmagnetfluss über die Luftspalte geführt wird, wird der Magnetfluss durch den magnetischen Widerstand an den Luftspalten beeinflusst. Folglich hängt der Hauptmagnetfluss durch die Spuleneinrichtung von den Spaltabständen ab. Wird das beschriebene Schwingungssystem zu mechanischen Schwingungen angeregt, kommt es zu einer regelmäßigen Veränderung der Spaltabstände an den Luftspalten, sodass der Hauptmagnetfluss durch die Spuleneinrichtung oszilliert. Durch die Oszillation des Hauptmagnetflusses durch die Spuleneinrichtung wird in der Spuleneinrichtung ein elektrischer Strom induziert. Die Leiterplattenvorrichtung weist eine Anschlusseinrichtung auf, die mit der Spuleneinrichtung elektrisch leitend verbunden ist. Die Anschlusseinrichtung ist dazu eingerichtet, den induzierten Strom aufzunehmen.

Durch die Erfindung ergibt sich der Vorteil, dass mechanische Schwingungen an einem Verbindungsort der Leiterplattenvorrichtung dazu verwendet werden können, einen elektrischen Strom bereitzustellen. Dadurch kann durch die Leiterplattenvorrichtung beispielsweise eine Sensoreinrichtung versorgt werden.

Die Erfindung weist auch Weiterbildungen auf, durch die sich weitere Vorteile ergeben.

Eine Weiterbildung der Erfindung sieht vor, dass die Magnetkerneinrichtungen jeweils eine Kammstruktur aufweisen, die entlang der Hauptrichtung verlaufen. Die jeweilige Kammstruktur weist Zinken auf, die senkrecht zur Hauptrichtung verlaufen und durch Nuten voneinander beabstandet sind. Mit anderen Worten verläuft eine Basis der Kammstruktur parallel zur Hauptrichtung. Auf der Basis stehen senkrecht zur Hauptrichtung die jeweiligen Zinken der Kammstruktur, wobei zwischen den Zinken die Nuten der jeweiligen Kammstruktur angeordnet sind. Die Zinken verlaufen innerhalb der Hauptebene der Leiterplattenvorrichtung.

Es ist vorgesehen, dass die Zinken der Kammstruktur der zweiten Leiterplatteneinrichtung in entsprechende Nuten der Kammstruktur der ersten Leiterplatteneinrichtung zumindest teilweise hineinragen. Mit anderen Worten sind die Zinken der zweiten Leiterplatteneinrichtung zumindest bereichsweise innerhalb entsprechender Nuten der Kammstruktur der ersten Leiterplatteneinrichtung angeordnet, sodass sich die Zinken der zweiten Leiterplatteneinrichtung bereichsweise zwischen den Zinken der Kammstruktur der ersten Leiterplatteneinrichtung befinden. Es ist vorgesehen, dass die Zinken der Kammstruktur der ersten Leiterplatteneinrichtung in entsprechende Nuten der Kammstruktur der zweiten Leiterplatteneinrichtung zumindest teilweise hineinragen.

Die Zinken der zweiten Leiterplatteneinrichtung sind in einer ersten Richtung, entlang der Hauptrichtung, durch jeweilige erste Luftspalte zu den Zinken der ersten Leiterplatteneinrichtung beabstandet. Die Zinken der zweiten Leiterplatteneinrichtung sind in einer zweiten, der ersten entgegengesetzten Richtung, entlang der Hauptrichtung durch jeweilige zweite Luftspalte zu den Zinken der ersten Leiterplatteneinrichtung beabstandet. Mit anderen Worten ist eine Breite der Nuten der Kammstruktur der ersten Leiterplatteneinrichtung größer als eine Breite der Zinken der Kammstruktur der zweiten Leiterplatteneinrichtung. Dadurch weisen die Zinken der Kammstruktur der zweiten Leiterplatteneinrichtung Spaltabstände zu den Zinken der ersten Kammstruktur der ersten Leiterplatteneinrichtung auf. Der erste Luftspalt liegt zwischen den Zinken der zweiten Leiterplatteneinrichtung und den Zinken der ersten Leiterplatteneinrichtung, wobei der erste Luftspalt ausgehend vom Zinken der zweiten Leiterplatteneinrichtung in der ersten Richtung verläuft, und der zweite Luftspalt ausgehend von dem Zinken der zweiten Leiterplatteneinrichtung in der zweiten Richtung verläuft. Der betreffende Zinken weist somit entlang einer ersten Längsseite den ersten Luftspalt auf und entlang einer zweiten Längsseite den zweiten Luftspalt. Ein Verhältnis der Spaltbreiten der ersten Luftspalte zu den Spaltbreiten der zweiten Luftspalte hängt von der Auslenkung der ersten Leiterplatteneinrichtung gegen die zweite Leiterplatteneinrichtung entlang der Hauptrichtung ab. Mit anderen Worten wird bei einer Auslenkung der ersten Leiterplatteneinrichtung aus der Grundstellung, je nach Richtung der Auslenkung, der Spaltabstand eines der Luftspalte verringert und der Spaltabstand des gegenüberliegenden Luftspalts vergrößert, wodurch sich ein Spaltverhältnis der Spaltabstände zwischen den Luftspalten verändert.

Durch die Änderung des Spaltverhältnisses wird der Hauptmagnetfluss durch die Spuleneinrichtung beeinflusst. Mit anderen Worten ändern sich die magnetischen Widerstände an den Luftspalten durch die Auslenkung. Durch die Änderung der magnetischen Widerstände kommt es zu einer Änderung des Hauptmagnetflusses durch die Spuleneinrichtung. Dies kann direkt durch die Änderung des Hauptmagnetflusses durch die magnetischen Widerstände oder durch eine erfolgende Änderung eines Verlaufs des Hauptmagnetflusses aufgrund der geänderten magnetischen Widerstände erfolgen.

Eine Weiterentwicklung der Erfindung sieht vor, dass zumindest einige der Zinken der Magnetkerneinrichtungen an den Luftspalten zueinander korrespondierende Feldbeeinflussungsstrukturen zur Magnetfeldbeeinflussung aufweisen. Mit anderen Worten ist es vorgesehen, dass die Geometrie zumindest einiger der Zinken an den Luftspalten angepasst ist, um ein gewünschtes Magnetfeld bereitzustellen. Das Magnetfeld kann beispielsweise in dem Fall, dass beide Zinken an den Luftspalten gerade Spaltkanten aufweisen, einen Verlauf haben, der nahezu senkrecht zu den Spaltkanten über den Luftspalt verläuft. Dies hat auch Auswirkungen auf eine magnetische Anziehung zwischen den Magnetkerneinrichtungen. Die dadurch hervorgerufene magnetische Anziehung in Abhängigkeit der Auslenkung kann jedoch einen für das Resonanzverhalten der Leiterplattenvorrichtung ungewünschten Einfluss ausüben. Um den Verlauf der magnetischen Anziehung in Abhängigkeit der Auslenkung zu beeinflussen, können die Spaltkanten der Zinken am Luftspalt einen Verlauf aufweisen, der von einem geraden Verlauf abweicht und Feldbeeinflussungsstrukturen bildet. Die Feldbeeinflussungsstrukturen können insbesondere dazu vorgesehen sein, das Magnetfeld derart zu führen, dass dieses neben dem beschriebenen senkrechten Verlauf über den Spalt einen Verlauf quer zu dem Spalt aufweist. Dadurch verändert sich auch die magnetische Anziehung in Abhängigkeit von der Auslenkung, wodurch das Resonanzverhalten derart verändert wird, dass es den gewünschten Verlauf aufweist.

Eine Weiterentwicklung der Erfindung sieht vor, dass die zueinander korrespondierenden Feldbeeinflussungsstrukturen Ausprägungen und zu den Ausprägungen korrespondierende Ausschnitte aufweisen. Mit anderen Worten ist es vorgesehen, dass einer der Zinken die Ausprägung aufweist, die aus der Spaltkante des Zinkens in Richtung des anderen Zinkens herausragt und der gegenüberliegende Zinken einen korrespondierenden Ausschnitt aufweist, welcher aus der Spaltkante des Zinkens ausgenommen ist. Die Ausprägung und der korrespondierende Ausschnitt können derart angeordnet sein, dass ab einer bestimmten Auslenkung die Ausprägung zumindest teilweise in den Ausschnitt hineinragt. Über die Seitenkanten kann ein Teil des Hauptmagnetflusses geführt werden, wodurch der parallele Anteil des Hauptmagnetflusses über den Luftspalt bereitgestellt werden kann.

Eine Weiterentwicklung der Erfindung sieht vor, dass die Magnetkerneinrichtungen als Eisenblechpaket eingerichtet sind, die in einer Innenlage der Leiterplatteneinrichtung angeordnet sind. Mit anderen Worten handelt es sich bei der jeweiligen Magnetkerneinrichtung um ein Eisenblechpaket, welches eine Innenlage der Leiterplatteneinrichtung bildet. Die Eisenblechpakete können bei der Leiterplattenfertigung in ausgefräste Taschen eingelegt und im Zuge eines Standard-Leiterplatten-Herstellungsprozesses verarbeitet oder verpresst sein.

Eine Weiterbildung der Erfindung sieht vor, dass die Magneteinrichtung Magneten aufweist, welche an der Basis zwischen den Zinken eingeordnet sind. Die Magneten können in Ausnehmungen angeordnet sein, welche für die Aufnahme der Magneten in die Leiterplatteneinrichtung und die Magnetkerneinrichtung gefräst sein können.

Eine Weiterbildung der Erfindung sieht vor, dass die Spuleneinrichtung Spuleneinheiten aufweist, wobei jeweils eine der Spulen aus Kupferbahnen gegenüberliegender Außenseiten der Leiterplatteneinrichtung und Durchkontaktierungen durch die Leiterplatteneinrichtung bereitgestellt ist. Mit anderen Worten umfasst jeweils eine der Spulen Kupferbahnen, die in einer Kupferlage auf einer ersten Außenseite der Leiterplatteneinrichtung verlaufen, sowie Kupferbahnen, die in einer Kupferlage auf einer zweiten Außenseite der Leiterplatteneinrichtung verlaufen. Die auf den gegenüberliegenden Außenseiten der Leiterplatteneinrichtung verlaufenden Kupferbahnen sind durch die Durchkontaktierungen durch die Leiterplatteneinrichtung miteinander verbunden. Ein Bereich der Magnetkerneinrichtung kann zwischen den Kupferbahnen und zwischen den Durchkontaktierungen angeordnet sein, sodass dieser durch die Spule umschlossen ist. Durch diese Weiterbildung ergibt sich der Vorteil, dass die Spulen durch Fertigungsverfahren der Leiterplattentechnik gefertigt werden können.

Eine Weiterbildung der Erfindung sieht vor, dass die Spuleneinheiten zwischen den Zinken angeordnet sind. Mit anderen Worten sind die Spulen an der Basis der Kammstruktur angeordnet, sodass sie vom Hauptmagnetfluss, der entlang der Basis verläuft, durchflossen werden.

Eine Weiterbildung der Erfindung sieht vor, dass die Spuleneinheiten entlang der Zinken angeordnet sind. Mit anderen Worten sind die Spulen an den Zinken der Kammstruktur angeordnet, sodass sie von dem Hauptmagnetfluss, der entlang der Zinken verläuft, durchflossen werden.

Eine Weiterbildung der Erfindung sieht vor, dass die Federeinrichtung als Spaltstruktur der Leiterplattenvorrichtung eingerichtet ist. Mit anderen Worten handelt es sich bei der Federeinrichtung um eine Struktur der Leiterplattenvorrichtung, welche durch ein Ausfräsen von Spaltstrukturen aus der Leiterplattenvorrichtung bereitgestellt wird. Die Spaltstrukturen können Balken bilden, welche quer zur Hauptrichtung verlaufen können, wodurch eine Biegung der Balken ermöglicht wird, die die Rückstellkraft bereitstellen kann. Es kann beispielsweise vorgesehen sein, dass die Leiterplatteneinrichtungen und die Federeinrichtung aus der Leiterplattenvorrichtung hergestellt sind, wobei die Federeinrichtung durch ein Bereitstellen von Spalten erzeugt wird, sodass der Bereich der Leiterplattenvorrichtung im Bereich der Federeinrichtung die Leiterplatteneinrichtungen derart verbindet, dass diese entlang der Hauptrichtung verschiebbar sind und dass die Federeinrichtung bei einer Auslenkung der Leiterplatteneinrichtungen zueinander eine rückstellende Kraft ausübt.

Eine Weiterbildung der Erfindung sieht vor, dass die Magnetkerneinrichtung jeweils eine Klauenpolstruktur aufweist, welche aus alternierend angeordneten Klauen aus zwei gegenüberstehenden Basisflächen gebildet ist. Mit anderen Worten weist die Magnetkerneinrichtung zwei Basisflächen auf, die parallel zueinander angeordnet sind. Eine jeweilige der Basisflächen weist entlang einer Klauenkante eine Reihe von Klauen auf, die senkrecht zur Basisfläche angeordnet sind und durch Nuten voneinander beabstandet sind. Mit anderen Worten umfasst eine jeweilige Magnetkerneinrichtung zwei Basisflächen. Die Basisflächen können parallel zur Hauptebene angeordnet sein und übereinander angeordnet sein. Entlang der Klauenkante der Basisflächen sind die Klauen angeordnet, welche aus der Hauptebene herausragen und durch die Nuten voneinander beabstandet sind. Die Basisflächen sind derart zueinander angeordnet, dass die Klauenkanten entlang einer gleichen Richtung verlaufen und sich die Klauen der jeweiligen Basisflächen abwechseln. Die Klauen einer der Basisflächen können in Nuten der anderen Basisfläche ragen. Es ist vorgesehen, dass die Klauenpolstrukturen der beiden Magnetkerneinrichtungen entlang ihrer Klauenkanten gegenüberliegend angeordnet sind, wobei eine Klaue der ersten Klauenpolstruktur gegenüber einer Klaue der zweiten Klauenpolstruktur angeordnet ist. Die Klauen sind durch den Luftspalt voneinander getrennt. Mit anderen Worten ist die Klauenkante der ersten Magnetkerneinrichtung, entlang derer die Klauenpolstruktur der ersten Magnetkerneinrichtung verläuft, gegenüberliegend der Klauenkante der zweiten Magnetkerneinrichtung, entlang derer die Klauenpolstruktur der zweiten Magnetkerneinrichtung verläuft, angeordnet. Dabei ist eine Klaue der ersten Magnetkerneinrichtung gegenüber einer Klaue der zweiten Magnetkerneinrichtung angeordnet. Die Klauenkanten sind parallel zur Hauptrichtung angeordnet. Es ist vorgesehen, dass durch eine Auslenkung der Leiterplatteneinrichtungen entlang der Hauptrichtung die Klauen der Magnetkerneinrichtungen gegeneinander verschoben werden, sodass ein Überdeckungsbereich der gegenüberliegenden Klauen entlang des Luftspalts verändert wird, wodurch der Hauptmagnetfluss über den Luftspalt verändert wird. Mit anderen Worten kann vorgesehen sein, dass in der Grundstellung eine Fläche einer Klaue der ersten Magnetkerneinrichtung gegenüber einer Fläche einer Klaue der zweiten Magnetkerneinrichtung angeordnet ist. Der Magnetfluss kann durch die Flächen über den Luftspalt verlaufen. Kommt es zu einer Auslenkung der Leiterplatteneinrichtungen, verschieben sich die Flächen der gegenüberliegenden Klauen zueinander und ein Überlappungsbereich der Flächen wird reduziert. Dadurch kommt es zu einer Erhöhung des magnetischen Widerstands über den Luftspalt.

Eine Weiterbildung der Erfindung sieht vor, dass die Magnetkerneinrichtungen derart eingerichtet sind, dass ab einem bestimmten Verschiebeweg entlang der Hauptrichtung eine Klaue einer der Magnetkerneinrichtungen gegenüber einer direkt benachbarten Klaue der anderen Magnetkerneinrichtung angeordnet ist, sodass der Hauptmagnetfluss durch die Spuleneinrichtung umgedreht wird.

Ein zweiter Aspekt der Erfindung betrifft eine Vorrichtung, die eine Leiterplatteneinrichtung gemäß dem ersten Aspekt der Erfindung aufweist. Die Vorrichtung kann beispielsweise eine Sensoreinrichtung aufweisen, die elektrisch leitend mit der Anschlusseinrichtung der Leiterplatteneinrichtung verbunden ist, um durch die Leiterplatteneinrichtung mit elektrischer Energie versorgt zu werden. Die Vorrichtung kann eine Halteeinrichtung aufweisen, an der die Leiterplatteneinrichtung angeordnet ist. Die Halteeinrichtung kann dazu vorgesehen sein, eine mechanische Verbindung zu einem vibrierenden Element herzustellen, um eine mechanische Schwingung des Elements auf die Leiterplatteneinrichtung zu übertragen und damit die Leiterplatteneinrichtung zur Schwingung anzuregen. Die Vorrichtung kann beispielsweise eine Sensoreinrichtung sein.

Unabhängig vom grammatikalischen Geschlecht eines bestimmten Begriffes sind Personen mit männlicher, weiblicher oder anderer Geschlechteridentität mit umfasst.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren gezeigten Merkmale und Merkmalskombinationen können nicht nur in der jeweils angegebenen Kombination, sondern auch in anderen Kombinationen von der Erfindung umfasst sein. Es können insbesondere auch Ausführungen und Merkmalskombinationen von der Erfindung umfasst sein, die nicht alle Merkmale eines ursprünglich formulierten Anspruchs aufweisen. Es können darüber hinaus Ausführungen und Merkmalskombinationen von der Erfindung umfasst, die über die in den Rückbezügen der Ansprüche dargelegten Merkmalskombinationen hinausgehen oder von diesen abweichen.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

In den Figuren zeigen:
FIG 1 zeigt eine schematische Darstellung einer Leiterplattenvorrichtung;
FIG 2 zeigt eine schematische Darstellung zwei zueinander korrespondierender Magnetkerneinrichtungen;
FIG 3 zeigt zwei zueinander korrespondierende Magnetkerneinrichtung, welche Feldbeeinflussungsstrukturen aufweisen um das Magnetfeld im Bereich der Luftspalte zu verändern;
FIG 4 zeigt einen Verlauf der magnetischen Kraft in Abhängigkeit von einer Auslenkung der Leiterplatteneinrichtungen;
FIG 5 zeigt eine schematische Darstellung eines Hauptmagnetflusses durch die Leiterplattenvorrichtung bei einer maximalen Auslenkung der Leiterplattenvorrichtung in eine erste Richtung;
FIG 6 zeigt eine schematische Darstellung eines Hauptmagnetflusses durch die Leiterplattenvorrichtung bei einer maximalen Auslenkung der Leiterplattenvorrichtung in eine zweite Richtung;
FIG 7 zeigt eine schematische Darstellung einer weiteren Ausführung einer Leiterplattenvorrichtung.
FIG 8 zeigt eine weitere schematische Darstellung der Ausführung einer Leiterplattenvorrichtung der FIG 7.

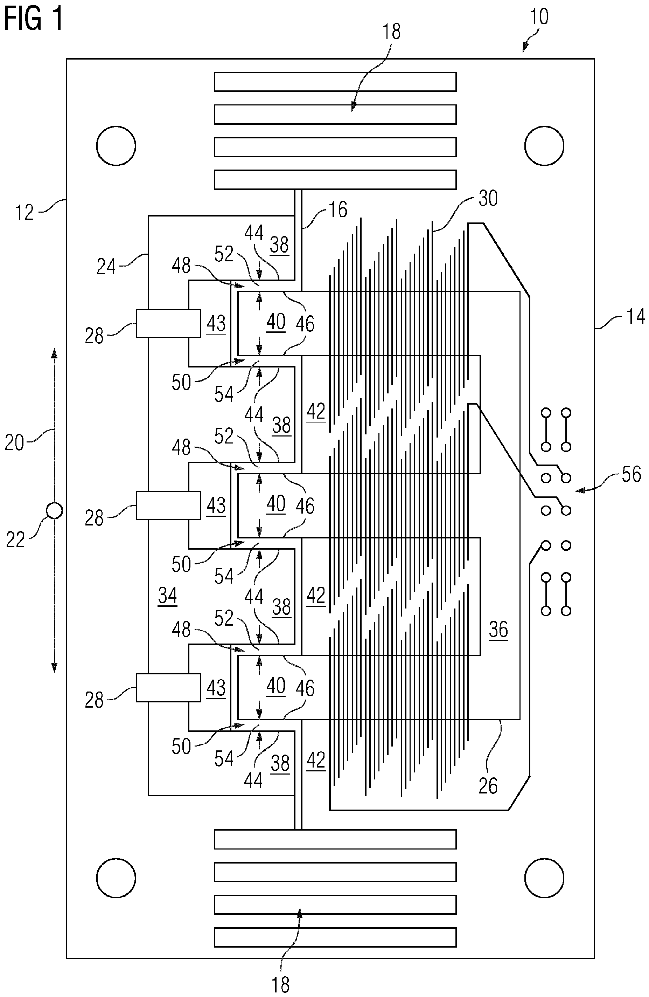

FIG 1 zeigt eine schematische Darstellung einer Leiterplattenvorrichtung.

Die Leiterplattenvorrichtung 10 kann aus einer Leiterplatte gefertigt worden sein. Die Leiterplattenvorrichtung kann eine erste Leiterplatteneinrichtung 12 und eine zweite Leiterplatteneinrichtung 14 aufweisen. Die erste Leiterplatteneinrichtung 12 kann von der zweiten Leiterplatteneinrichtung 14 durch einen Trennspalt 16 getrennt sein. Die erste Leiterplatteneinrichtung 12 kann zu der zweiten Leiterplatteneinrichtung 14 durch eine Federeinrichtung 18 gehalten werden. Die Federeinrichtung 18 kann Spaltstrukturen aufweisen, welche aus der Leiterplattenvorrichtung 12 herausgefräst sein können. Die Federeinrichtung 18 kann dazu vorgesehen sein, die Leiterplatteneinrichtungen 12,14 derart zu lagern, dass diese entlang des Trennspalts 16 voneinander beabstandet sind und entlang einer Hauptrichtung 20 zueinander verschiebbar gelagert sein können. Die Federeinrichtung 18 kann dazu eingerichtet sein, die erste Leiterplatteneinrichtung 12 gegenüber der zweiten Leiterplatteneinrichtung 14 in einer Grundstellung 22 zu halten. Die erste Leiterplatteneinrichtung 12 kann gegenüber der zweiten Leiterplatteneinrichtung 14 entlang der Hauptrichtung 20 verschoben werden, wobei bei einer Auslenkung der ersten Leiterplatteneinrichtung 12 aus der Grundstellung 22, die erste Leiterplatteneinrichtung 12 durch die Federeinrichtung 18 mit einer Rückstellkraft beaufschlagt werden kann, welche in Richtung der Grundstellung 22 wirken kann. Die erste Leiterplatteneinrichtung 12 kann eine erste Magnetkerneinrichtung 24 aufweisen. Die zweite Leiterplatteneinrichtung 14 kann eine zweite Magnetkerneinrichtung 26 aufweisen. Die erste Leiterplatteneinrichtung 12 kann eine Magneteinrichtung 28 aufweisen, wobei die Magneteinrichtung 28 Permanentmagneten als Magneteinheiten aufweisen kann, welche dazu eingerichtet sein können, ein Magnetfeld bereitzustellen. Die zweite Leiterplatteneinrichtung 14 kann Spulen einer Spuleneinrichtung 30 aufweisen. Die Magnetkerneinrichtungen 24, 28 können dazu eingerichtet sein, einen Hauptmagnetfluss 32 des Magnetfeldes derart zu führen, dass dieser durch die Magneteinrichtung 28 und die Spuleneinrichtung 30 verläuft. Die Magnetkerneinrichtungen 24,26 können als Kammstrukturen eingerichtet ist, welche eine jeweilige Basis 34, 36 aufweisen, welche parallel zur Hauptrichtung 20 verlaufen können. Aus der jeweiligen Basis 34, 36 können jeweilige Zinken 38, 40 herausstehen, welche senkrecht zur Hauptrichtung 20 verlaufen können. Die Zinken 38, 40 können durch Nuten 42, 43 beabstandet sein. Die Zinken 40 der zweiten Leiterplatteneinrichtung 14 können zumindest teilweise in jeweilige Nuten 43 der Magnetkerneinrichtung 24 der ersten Leiterplatteneinrichtung 12 hineinragen.

Spaltkanten 44, 46 der Zinken 38, 40 können an dem Trennspalt 16 gegenüberliegen und Luftspalten 48, 50 bilden. Die ersten Luftspalten 48 können einen Abstand zwischen der zweiten Magnetkerneinrichtung 26 zu der ersten Magnetkerneinrichtung 24 in einer ersten Richtung aufweisen. Die zweiten Luftspalte 50 können einen Abstand zwischen der zweiten Magnetkerneinrichtung 26 zu der ersten Magnetkerneinrichtung 24 in der entgegengesetzten Richtung in Bezug auf die Hauptrichtung 20 aufweisen. Die Luftspalten 48, 50 können Abstände 52, 54 zueinander aufweisen.

Wenn die erste Leiterplatteneinrichtung 12 in der Grundstellung 22 angeordnet ist, können die ersten Luftspalt 48 und die zweite Luftspalte 50 identische Spaltabstände 52, 54 aufweisen. Kommt es zu einer Auslenkung der ersten Leiterplatteneinrichtung 12 aus der Grundstellung 22 kann, je nach Richtung der Auslenkung, eine Art der Spaltabstände 52, 54 zunehmen und die andere Art der Spaltabstände 52, 54 abnehmen.

Dadurch wird der magnetische Widerstand an den Luftspalten 48, 50 verändert, wodurch der Hauptmagnetfluss 32 durch diese Spuleneinrichtung 30 verändert wird. Aufgrund der Änderung des Hauptmagnetflusses 32 durch die Spuleneinrichtung 30 kommt es zu einer Induktion von elektrischem Strom in der Spuleneinrichtung 30. Der induzierte Strom kann an einer Kontaktierungseinrichtung 56 bereitgestellt werden. Die Spuleneinrichtung 30 kann Spulen aufweisen, welche zwei Spulenbahnen auf gegenüberliegenden Seiten der zweiten Leiterplatteneinrichtung 14 aufweisen kann, die durch Durchkontaktierungen miteinander verbunden sein können.

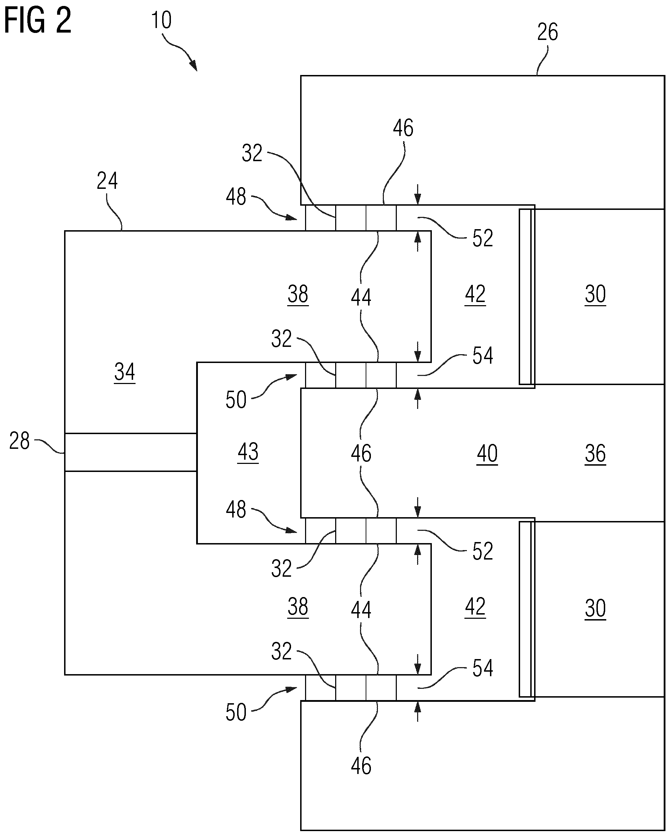

FIG 2 zeigt eine schematische Darstellung zwei zueinander korrespondierender Magnetkerneinrichtungen.

Zwischen den Magnetkerneinrichtung 24, 26 können sich im Bereich der Zinken 38, 40 die Luftspalte 48, 50 befinden welche Bereiche des Trennspaltes 16 zwischen den gegenüberliegenden Spaltkanten 44,46 beschreiben können. Gezeigt die Anordnung der ersten Magnetkerneinrichtung 24 in Bezug auf die zweite Magnetkerneinrichtung 24 in der Grundstellung 22 in welcher beide Luftspalte 48, 50 identische Spaltabstände 52, 54 aufweisen können. Bei einer Auslenkung der ersten Leiterplatteneinrichtung 12 aus der Grundstellung 22 kann es neben der Rückstellkraft durch die Federeinrichtung zu einer anziehend wirkenden Kraft aufgrund des Magnetfelds kommen. In der gezeigten FIG 2 sind die Spaltkanten 44, 46 parallel zueinander und gerade ausgerichtet, wodurch der Hauptmagnetfluss 32 nahezu senkrecht zu den Spaltkanten 44, 46 der Zinken 38, 40 über die Luftspalte 48, 50 verläuft.

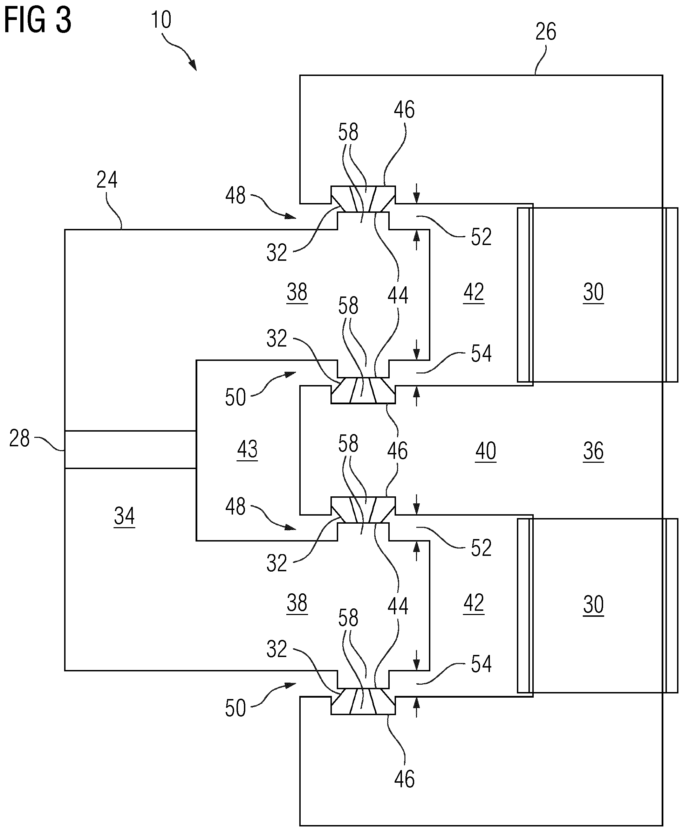

FIG 3 zeigt zwei zueinander korrespondierende Magnetkerneinrichtung, welche Feldbeeinflussungsstrukturen aufweisen um das Magnetfeld im Bereich der Luftspalte zu verändern.

FIG 3 zeigt ebenfalls die Luftspalte 48, 50, wie in FIG 2. In FIG 3 sind jedoch Feldbeeinflussungsstrukturen 58 bereitgestellt. Der Zweck der Feldbeeinflussungsstrukturen 58 besteht darin, dass ein Verlauf des Hauptmagnetflusses 32 über die Luftspalte 48, 50 gegenüber Zinken 38, 40 ohne die Feldbeeinflussungsstrukturen 58 verändert wird. Es kann insbesondere vorgesehen sein, dass zusätzlich zu dem senkrechten Verlauf des Hauptmagnetflusses 32 über die Luftspalte 48, 50 eine Komponente des Hauptmagnetflusses 32 ergänzt wird, welche parallel zu den Luftspalten 48, 50 verlaufen kann. Dadurch kann ein Kraftverlauf der bei einer Auslenkung anziehend wirkenden Magnetkraft zwischen den Magnetkerneinrichtungen 24, 26 verändert werden. Es kann vorgesehen sein, dass die Feldbeeinflussungsstrukturen 58 Ausprägungen aufweisen, welche aus der Spaltkante 44 der ersten der Magnetkerneinrichtung 24 herausragen. Die Feldbeeinflussungsstrukturen 58können Aussparungen aufweisen, welche an der Spaltkante 46 der zweiten der Magnetkerneinrichtung 26 in den Zinken 40 hineinragen. Bei einer Reduzierung des Spaltabstandes 52, 54 kann die Ausprägung des einen Zinken 38 in die Aussparung des gegenüberliegenden Zinken 40 hineinragen. Zwischen Seitenkanten der Feldbeeinflussungsstrukturen 58 können dann die seitlich verlaufenden Anteile des Hauptmagnetflusses 32 geführt werden. Dadurch verändert sich die magnetische Kraft zwischen den Magnetkerneinrichtungen 24, 26 und somit das Resonanzverhalten der Leiterplattenvorrichtung 10.

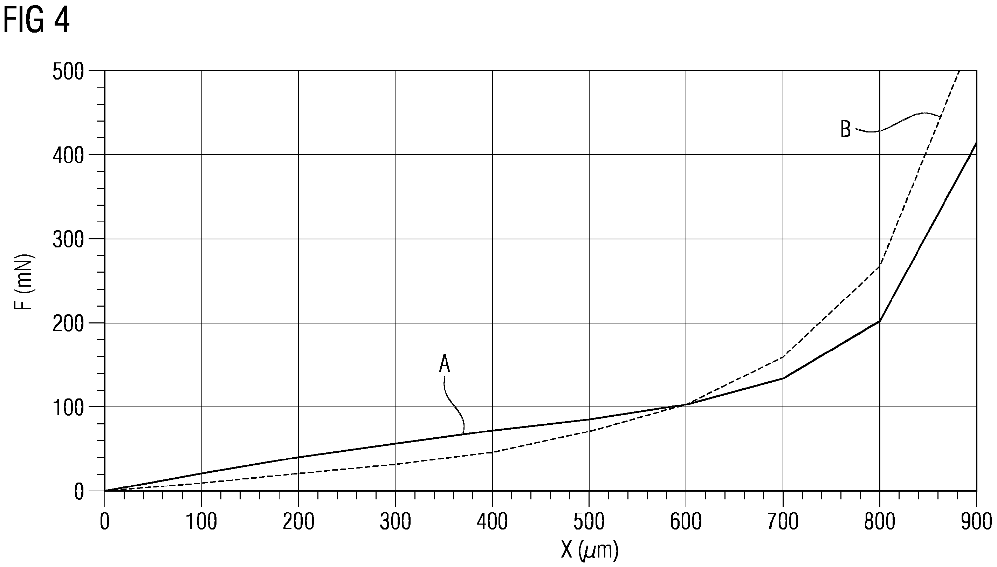

FIG 4 zeigt einen Verlauf der magnetischen Kraft in Abhängigkeit von einer Auslenkung der Leiterplatteneinrichtungen.

Gezeigt ist der Verlauf der magnetischen Kraft F für eine Leiterplattenvorrichtung 10, wie sie in FIG 2 gezeigt ist und eine Leiterplattenvorrichtung 10 wie sie in FIG 3 gezeigt ist. Man kann erkennen, dass der Kraftverlauf A der Leiterplattenvorrichtung 10 mit den Feldbeeinflussungsstrukturen 58 in den Luftspalten 48, 50 in einem weiten Bereich etwa linear verläuft, während der Kraftverlauf B der Variante der Leiterplattenvorrichtung 10 ohne die Feldbeeinflussungsstrukturen 58 näherungsweise einem quadratischen Verlauf folgt.

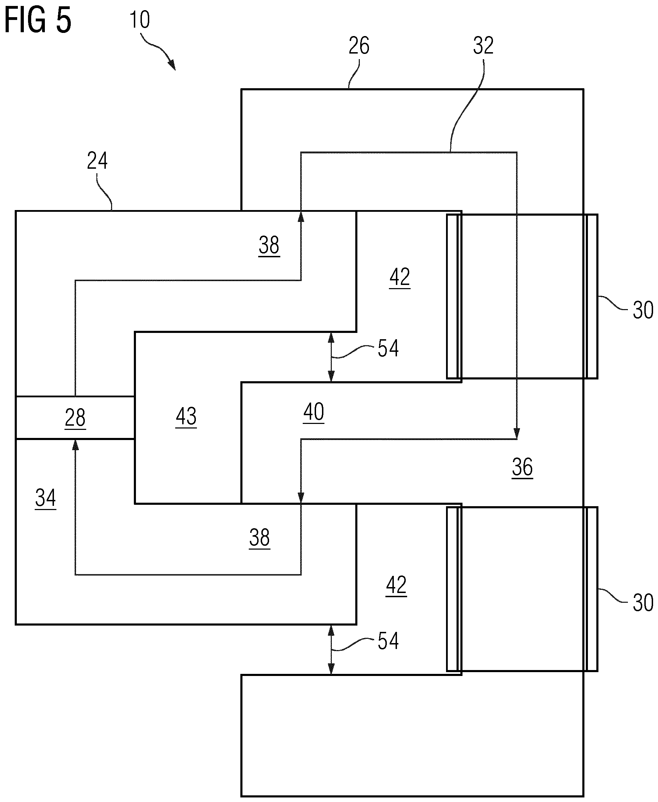

FIG 5 zeigt eine schematische Darstellung eines Hauptmagnetflusses durch die Leiterplattenvorrichtung bei einer maximalen Auslenkung der Leiterplattenvorrichtung in eine erste Richtung.

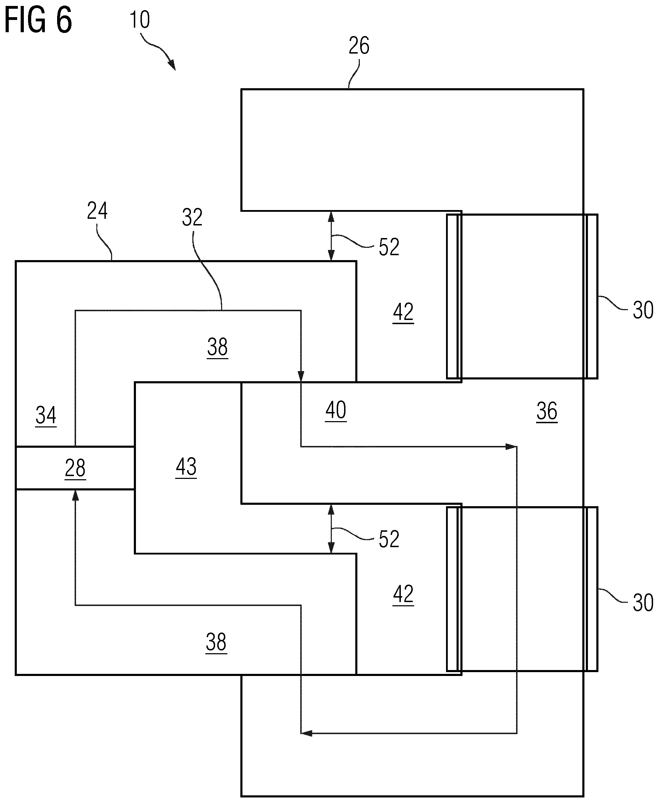

FIG 6 zeigt eine schematische Darstellung eines Hauptmagnetflusses durch die Leiterplattenvorrichtung bei einer maximalen Auslenkung der Leiterplattenvorrichtung in eine zweite Richtung.

An dem Verlauf des Hauptmagnetflusses 32 ist zu erkennen, dass dieser durch die andere der Spulen verläuft.

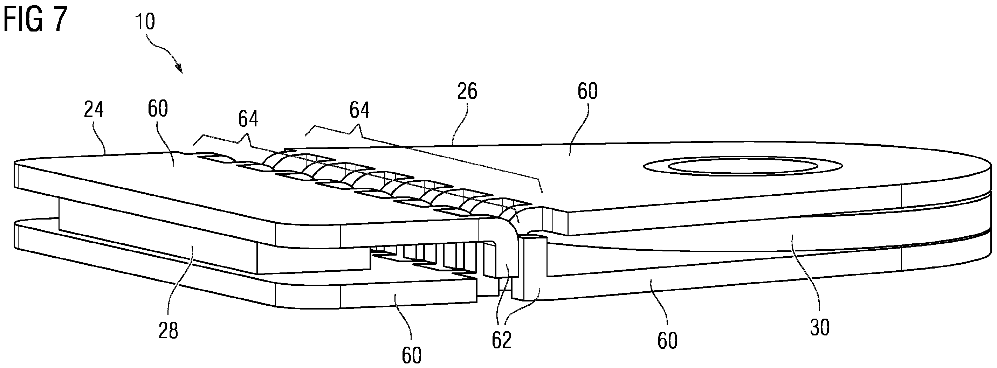

FIG 7 zeigt eine schematische Darstellung einer weiteren Ausführung einer Leiterplattenvorrichtung.

Die erste Leiterplatteneinrichtung 12 der Leiterplattenvorrichtung 10 kann die Magneteinrichtung 28 aufweisen, welche zwischen zwei Basisflächen 60 einer ersten Magnetkerneinrichtung 24 angeordnet sein kann. Die zwei Basisflächen 60 der ersten Magnetkerneinrichtung 24 können parallel zueinander und parallel zu der Hauptebene angeordnet sein.

Die zweite Leiterplatteneinrichtung 14 der Leiterplattenvorrichtung 10 kann die Spuleneinrichtung 30 aufweisen, welche zwischen zwei Basisflächen 60 einer zweiten Magnetkerneinrichtung 26 angeordnet sein kann. Die zwei Basisflächen 60 der zweiten Magnetkerneinrichtung 24, 26 können ebenfalls parallel zueinander und parallel zu der Hauptebene angeordnet sein.

Die Basisflächen 60 können jeweilige Klauen 62 aufweisen, welche senkrecht zu der Hauptebene angeordnet sein können und in Richtung der gegenüberliegenden Basisfläche 60 der Magnetkerneinrichtung 24, 26 ausgerichtet sein können. Die Klauen 62 können entlang einer Klauenkante 64 angeordnet sein. Entlang der Klauenkante 64 können sich die Klauen 62 der beiden Basisflächen 60 alternierend abwechseln und eine Klauenstruktur bilden. Die Klauenstruktur der ersten Magnetkerneinrichtung 24 kann entlang des Trennspalts 16 gegenüber der Klauenstruktur der zweiten Magnetkerneinrichtung 26 angeordnet sein. Die Magnetkerneinrichtungen 24, 26 können entlang der Hauptrichtung 20 zueinander verschiebbar gelagert sein.

Gezeigt ist die Anordnung der Magnetkerneinrichtungen 24, 26 zueinander in der Grundstellung 22. In der Grundstellung 22 können Spaltkanten 44, 46 gegenüberliegender Klauen 62 verschiedener Magnetkerneinrichtungen 24, 26 gegenüberliegend angeordnet sein. Normal zu der Spaltkante 44 gesehen sind die Spaltkanten 46 der gegenüberliegenden Klauen 62 somit deckungsgleich. Bei einer Verschiebung entlang der Hauptrichtung 20 kann die sich überlappende Fläche der gehgenüberliegenden Klauen 62 abnehmen und somit ein magnetischer Widerstand an dem Luftspalt 48 zunehmen, wodurch der Hauptmagnetfluss 32 durch die Spuleneinrichtung 30 abnehmen kann. Ab einer gewissen Verschiebung kann es zu einer Überlagerung der Spaltkante 44 einer Klaue 62 mit einer Spaltkante 46 einer Klaue 62 kommen, die neben der Klaue 62 angeordnet ist, welche der Klaue 62 in der Grundstellung 22 gegenübersteht. Dadurch, dass die benachbarte Klaue 62 aus der anderen Basis 60 herausragt, wird der aus der Klaue 62 heraustretende Magnetfluss 32 statt in die ursprüngliche Basisfläche 60 in die andere Basisfläche 60 geführt. Dadurch wird der Verlauf des Hauptmagnetflusses 32 durch die Spuleneinrichtung 30 umgedreht.

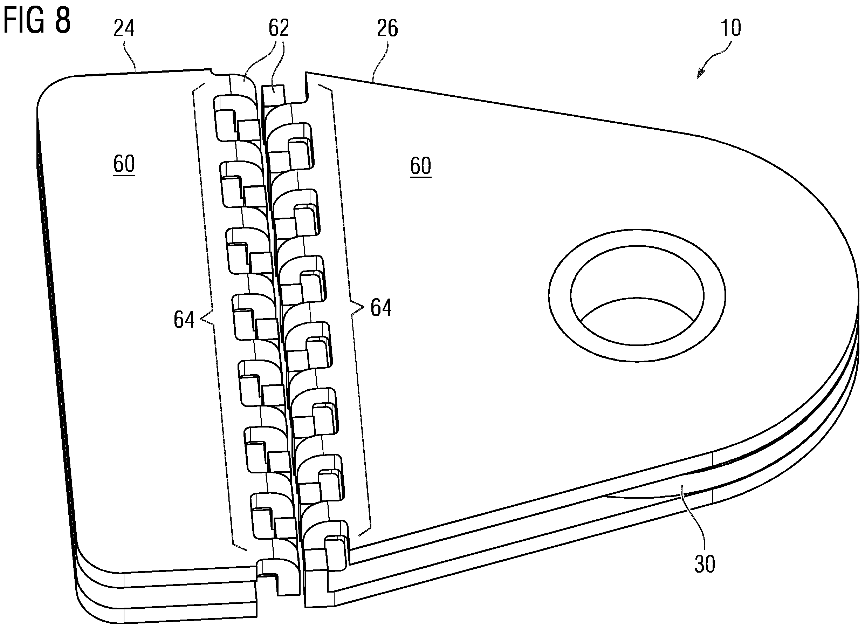

FIG 8 zeigt eine weitere schematische Darstellung der Ausführung einer Leiterplattenvorrichtung der FIG 7.

Als Grundprinzip für die Erfindung wird ein magnetischer Kreis mit Permanentmagneten für den Harvester herangezogen. Die dafür notwendigen Komponenten sind ein magnetisierbarer Eisenkern, ein Luftspalt, eine Wicklung und Dauermagnete. Diese Komponenten werden in eine Leiterplatte eingebracht, wobei der metallische Eisenkern und die Magnete in entsprechende Ausschnitte, Taschen oder Hohlräume in der Leiterplatte eingesetzt werden. Die Wicklungen können durch Leiterbahnen und Durchkontaktierungen gebildet werden, so dass leitende Strukturen entstehen, welche sich um Abschnitte der Eisenkerne winden. Die Leiterplatte ist des Weiteren so ausgeformt, dass sich ein oder mehrere Luftspalte zwischen den Eisenkernen ergeben. Weiters verfügt die Leiterplatte über Strukturen, die es erlauben einen Teil der Leiterplatte relativ zu einem anderen Teil zu verschieben. Dazu können zum Beispiel Ausschnitte in die Leiterplatte gefräst werden, um Verbindungsbalken zwischen den beiden Teilen der Leiterplatte zu realisieren. Die Verbindungsbalken bestehen aus Leiterplattenmaterial, typischerweise aus glasfaserverstärktem Kunststoff, und können elastisch verformt werden. Dadurch kann erreicht werden, dass die beiden Teile der Leiterplatte sich zueinander verschieben und sich die Breite eines Luftspaltes, bzw. Verhältnisse zwischen gepaarten Luftspalten zueinander verändern. Dies führt zu einer Veränderung des Magnetischen Flusses in den Eisenkernen. Diese Veränderungen können mittels einer oder mehrerer Wicklungen in induzierte Ströme und Spannungen umgesetzt werden, womit elektrische Energie aus dem System entnommen werden kann.

Die wichtigste Kenngröße dieses Systems aus mechanischer und magnetischer Anordnung ist der Frequenzgang, welcher die entnehmbare elektrische Energie bei mechanischer Anregung als Funktion der Frequenz beschreibt.

Typisch haben solche Systeme eine Resonanzfrequenz, bei der eingebrachte mechanische Anregung besonders gut in elektrische Energie umgewandelt werden kann. In der Praxis ist es aber oft so, dass das Frequenzspektrum der mechanischen Anregung keine ausgezeichneten Frequenzen enthält (z.B. die Vibrationen in einem Drehgestell eines Zuges ist eher rauschartig) sondern eine breitbandige Anregung zu erwarten ist. Für diesen Fall ist ein System mit einer ausgezeichneten Resonanzfrequenz nicht geeignet, da nur ein kleiner Bereich des Energiespektrums der mechanischen Vibration genutzt werden kann.

Die Resonanzfrequenz hängt im Wesentlichen von den Eigenschaften der Federelemente und der schwingenden Masse ab. Die Federelemente erzeugen dabei eine Kraft, welche die Anordnung in eine Ausgangsposition zurückbringt. In der Ausgangsposition ist die Federkraft null. Werden die Federelemente ausgelenkt, so steigt die Kraft näherungsweise linear mit der Auslenkung.

Zusätzlich verursacht aber der magnetische Kreis eine weitere Kraft. Werden paarweise Luftspalte eingesetzt, so ist es möglich eine Kraft zu erzeugen, welche in der Ausgangsposition null ist, jedoch bei Auslenkung so wirkt, dass die Auslenkung verstärkt wird. Diese magnetische Kraft wirkt also der Federkraft entgegen, verhält sich aber grundsätzlich nicht linear zur Auslenkung.

Durch Abstimmung der Federkraft und der Magnetischen Kraft aufeinander, kann in einem Bereich eine näherungsweise Kompensation der beiden Kräfte erzielt werden. Dies reduziert die Ausprägung der Resonanzfrequenz und führt zu breitbandigem Verhalten über der Frequenz.

Die tatsächliche Realisierung der Erfindung kann mittels Standardprozess bei der Leiterplattenfertigung und der Eisenkernfertigung durchgeführt werden.

Dazu sind exemplarisch folgende Grafiken als mögliche Realisierung zu nennen:
Form eines möglichen Eisenblechpakets in "E"-Struktur entweder als Einzelplatten oder als gesamter Kern verpresst.

Leiterplattendesign für die Integration des Eisenblechpakets mit Mäanderstruktur um Bewegung der Eisenkerne relativ zueinander zu ermöglichen. Weiters sind oben und unten horizontale Schlitze in die Leiterplatte eingebracht, mit denen horizontale Balken entstehen, die als Federelemente dienen. Wird z.B. der linke Teil der Leiterplatte festgehalten, so kann der rechte Teil mit dem E-förmigen Eisenkern nach oben und unten schwingen. Die Leiterplatte kann mehrere Kupferlagen enthalten. Es sind zumindest zwei Kupferlagen auf den Außenseiten (Top und Bottom) nötig um die Wicklungen herzustellen. Die Blechpakete werden bei der Leiterplattenfertigung in ausgefräste Taschen eingelegt und im Zuge des Standard Leiterplatten-Herstellungsprozesses verarbeitet bzw. verpresst. Danach werden die Ausnehmungen für die Aufnahme der Dauermagneten in die Leiterplatten/Blechstruktur gefräst. In der Grafik sind die Ausnehmungen als drei waagrechte Unterbrechungen im linken Eisenkern skizziert. Die Magnete werden aufgrund der Temperaturen, die beim Leiterplatten-Herstellprozess notwendig sind, nicht wie die Eisenkerne eingebracht, sondern in die fertige Leiterplatte eingesetzt und fixiert - zum Beispiel mit Klebstoff.

Diese Form der Leiterplattenrealisierung des Harvesters hat eine Vorzugsbewegungsrichtung. In dieser ändert sich durch eine Bewegung (z.B. Vibrationen) der Abstand der Luftspalte zwischen dem feststehenden und beweglichen Teil, und der magnetische Fluss induziert in den Windungen eine Spannung und einen daraus resultierenden Strom, welcher für die Energieversorgung eines Sensors genutzt werden kann. Es können auch mehrere solcher Strukturen mit unterschiedlichen Vorzugsbewegungsrichtungen auf einer Leiterplatte realisiert werden.

In einer weiteren Optimierung der Anordnung kann der Zusammenhang zwischen magnetischer Kraft und Auslenkung verändert werden. Dies erfolgt durch Veränderung der Geometrie des Spaltes. Es kann zum Beispiel auf einer Seite des Spaltes eine Ausprägung und auf der anderen Seite des Spaltes ein Ausschnitt erzeugt werden. Daraus ergibt sich eine Feldverzerrung, die den Kraftverlauf verändert. Strebt man nach einer weitgehenden Linearisierung des Kraftverlaufes der magnetischen Kraft, kann dadurch über einem weiten Auslenkungsbereich die Federkraft mit der magnetischen Kraft kompensiert werden, was ein besonders breitbandiges Frequenzverhalten bringt. Dadurch wird der Frequenzgang unabhängig von der Masse des bewegten Teils der Leiterplatte. Die Dämpfung des Systems erfolgt mittels entnommener elektrischer Energie, und es kann im Rahmen der Dimensionierung des magnetischen Kreises die Masse und damit auch die entnehmbare elektrische Energie bei vorgegebener Vibration erhöht werden.

Eine dritte Optimierung kann durch eine Veränderung der Spaltgeometrie erzielt werden, bei der die magnetische Kraft in Abhängigkeit von ihrer Auslenkung zusätzlich ihre Richtung ändert. Die Spaltgeometrie kann so gestaltet werden, dass z. B. bei größer werdenden Auslenkungen die Kraft zunehmend quer zur Bewegungsrichtung und weniger entlang der Bewegungsrichtung wirkt. Damit kann erzielt werden, dass die magnetische Kraft durch ihre Richtungsänderung die Verformung der Balken bei höheren Auslenkungen weniger stark zunimmt (zum Beispiel, wenn vermehrt Zugkräfte anstelle von auslenkenden Querkräften auf die Balken wirken). Dadurch kann der effektive Anteil der magnetischen Kraft, welcher zur Auslenkung der Balken beiträgt, bei hohen Auslenkungen verringert werden, und die magnetische Wirkung und die Federwirkung aneinander angeglichen werden.

Bisher wurden in verteilten Funksystemen Batterielösungen zur Energieversorgung verwendet. Diese haben den Nachteil, dass sie einen erhöhten Wartungsaufwand erfordern. Das äußert sich dadurch, dass die Energiequelle ein zu niedriges Level für den Betrieb des Sensors erreicht und der Servicemitarbeiter vor Ort den Sensor komplett tauschen oder die Energiequelle auswechseln muss. Um dem entgegenwirken zu können müssen neue Arten der Energieversorgung, wie zum Beispiel Energy Harvester, inkludiert werden. Das führt dazu, dass der Betrieb von autonomen Sensoren über eine längere Zeit möglich wird. Die oben genannte Erfindung beschreibt eine mögliche Realisierung einer neuartigen Form des elektromagnetischen Harvesters, der im Gegensatz zu bestehenden elektromagnetischen Harvestern direkt in Leiterplatten integriert werden kann. Die Integration von Fremdmaterialien (z.B. Metallkörpern zur besseren Wärmeabfuhr etc.) gehört in der Leiterplattenfertigung mittlerweile zum Stand der Technik. Der wesentliche Vorteil von einer integrierten Lösung in Leiterplattentechnologie ist der, dass bei der weiteren Fertigung der elektrischen Baugruppe alle notwendigen Komponenten (elektronische Bauteile, mechanische Bauteile, ...) auf einer gemeinsamen Leiterplatte aufgebracht werden können. Es entfällt die Notwendigkeit von eigenständigen elektromechanischen Bauteilen zur Energiegewinnung und die damit verbundenen erhöhten Kosten bzw. Probleme von Aufbau und Verbindungstechnik, welche besonders in mechanisch rauer Umgebung (z.B. starke Vibrationen) zu Problemen und Einschränkungen führen.

Zusätzlich ist es möglich, einen Großteil der Leiterplatte mit integriertem Harvester für Schaltungen (z.B. Sensoren, Kapazitive Ladungsspeicher, Mikrocontroller, Funkbaugruppen, Displays, uvm. zu verwenden. Über die federnden Elemente welche als Teil der Leiterplatte realisiert sind können auch Leiterbahnen gelegt werden, was es ermöglicht elektrische Verbindungen zwischen dem feststehenden und dem auslenkbaren Teil der Leiterplatte herzustellen. Es ist sogar möglich, in die Federelemente auf diese Art Bewegungssensoren zu integrieren. Diese können beispielsweise durch Verformung der Leiterbahnen im Sinne von Dehnmessstreifen, welche zu Messbrücken zusammengefasst werden, realisiert werden.

### Bezugszeichenliste

- 10: Leiterplattenvorrichtung
- 12: erste Leiterplatteneinrichtung
- 14: zweite Leiterplatteneinrichtung
- 16: Trennspalt
- 18: Federeinrichtung
- 20: Hauptrichtung
- 22: Grundstellung
- 24: erste Magnetkerneinrichtung
- 26: zweite Magnetkerneinrichtung
- 28: Magneteinrichtung
- 30: Spuleneinrichtung
- 32: Hauptmagnetfluss
- 34: Basis der ersten Magnetkerneinrichtung
- 36: Basis der zweiten Magnetkerneinrichtung
- 38: Zinken der ersten Magnetkerneinrichtung
- 40: Zinken der zweiten Magnetkerneinrichtung
- 42: Nuten der zweiten Magnetkerneinrichtung
- 43: Nuten der ersten Magnetkerneinrichtung
- 44: erste Spaltkante
- 46: zweite Spaltkante
- 48: erster Luftspalt
- 50: zweiter Luftspalt
- 52: erste Spaltabstände
- 54: zweite Spaltabstände
- 56: Kontaktierungseinrichtung
- 58: Feldbeeinflussungsstrukturen
- 60: Basisfläche
- 62: Klaue
- 64: Klauenkante

## Patentansprüche

1. Leiterplattenvorrichtung (10), wobei die Leiterplattenvorrichtung (10) zwei parallel in einer Hauptebene angeordnete Leiterplatteneinrichtungen (12, 14) aufweist, die durch einen Trennspalt (16) in der Hauptebene voneinander getrennt sind, wobei
- die Leiterplatteneinrichtungen (12, 14) jeweilige Magnetkerneinrichtungen (24, 26) aufweisen, die dazu eingerichtet sind, einen Hauptmagnetfluss (32) durch eine Magneteinrichtung (28) einer ersten Leiterplatteneinrichtung (12) und eine Spuleneinrichtung (30) einer zweiten Leiterplatteneinrichtung (14) zu führen, wobei der Hauptmagnetfluss (32) über Luftspalten (48, 50) in dem Trennspalt (16) geführt ist,
- die Leiterplattenvorrichtung (10) eine Federeinrichtung (18) aufweist, die dazu eingerichtet ist, die erste Leiterplatteneinrichtung (12) entlang einer Hauptrichtung (20) gegen die zweite Leiterplatteneinrichtung (14) verschiebbar zu lagern und bei einer Auslenkung der ersten Leiterplatteneinrichtung (12) aus einer Grundstellung (22), die erste Leiterplatteneinrichtung (12) mit einer von der Auslenkung abhängigen Rückstellkraft zu beaufschlagen, sodass die zwei Leiterplatteneinrichtungen (12, 14) ein Schwingungssystemsystem bilden, dass ein vorgegebenes Resonanzverhalten aufweist,
**dadurch gekennzeichnet, dass**
durch eine Schwingung der ersten Leiterplatteneinrichtung (12) gegen die zweite Leiterplatteneinrichtung (14) Spaltabstände (52, 54) zwischen den Magnetkerneinrichtungen (24, 26) an den Luftspalten (48, 50) variieren, sodass eine Magnetflussdichte des Hauptmagnetflusses (32) durch die Spuleneinrichtung (30) variiert und in der Spuleneinrichtung (30) ein elektrischer Strom induziert wird.

2. Leiterplattenvorrichtung (10) nach Anspruch 1,
**dadurch gekennzeichnet, dass**
- die Magnetkerneinrichtungen (24, 26) eine jeweilige Kammstruktur aufweisen, die eine entlang der Hauptrichtung (20) verlaufende Basis (34) aufweisen, wobei
- die Kammstruktur jeweilige Zinken (38, 40) auf der Basis (34,36) aufweist, die senkrecht zur Hauptrichtung (20) angeordnet sind und die durch Nuten (42,43) voneinander beabstandet sind,
- Zinken (40) der Kammstruktur der zweiten Leiterplatteneinrichtung (14) in entsprechende Nuten (43) der Kammstruktur der ersten Leiterplatteneinrichtung (12) hineinragen, und Zinken (38) der Kammstruktur der ersten Leiterplatteneinrichtung (12) in entsprechende Nuten (42) der Kammstruktur der zweiten Leiterplatteneinrichtung (14) hineinragen.
- die Zinken (40) der zweiten Leiterplatteneinrichtung (14) in eine erste Richtung entlang der Hauptrichtung (20) durch jeweilige erste Luftspalten (48) zu den Zinken (38) der ersten Leiterplatteneinrichtung (12) beabstandet sind
- die Zinken (40) der zweiten Leiterplatteneinrichtung (14) in eine zweite Richtung entlang der Hauptrichtung (20) durch jeweilige zweite Luftspalten (50) zu den Zinken (38) der ersten Leiterplatteneinrichtung (12) beabstandet sind,
- ein Verhältnis der Spaltabstände (52) der ersten Luftspalten (48) zu den Spaltabständen (54) der zweiten Luftspalten (50) von der Auslenkung der ersten Leiterplatteneinrichtung (12) gegen die zweite Leiterplatteneinrichtung (14) entlang der Hauptrichtung (20) abhängt, und
- der Magnetfluss durch die Spuleneinrichtung (30) von dem Verhältnis abhängt.

3. Leiterplattenvorrichtung (10) nach Anspruch 1 oder 2,
**dadurch gekennzeichnet, dass**
zumindest einige der Zinken (38, 40) an den Luftspalten (48, 50) zueinander korrespondierende Feldbeeinflussungsstrukturen (58) zur Magnetfeldbeeinflussung aufweisen.

4. Leiterplattenvorrichtung (10) nach Anspruch 3,
**dadurch gekennzeichnet, dass**
die zueinander korrespondierende Feldbeeinflussungsstrukturen (58) Ausprägungen und zu den Ausprägungen korrespondierende Ausschnitte aufweisen.

5. Leiterplattenvorrichtung (10) nach einem der vorhergehenden Ansprüche,
**dadurch gekennzeichnet, dass**
die Magnetkerneinrichtungen (24, 26) als jeweiliges Eisenblechpaket eingerichtet sind, das in einer Innenlage der jeweiligen Leiterplatteneinrichtung (12, 14) angeordnet ist.

6. Leiterplattenvorrichtung (10) nach einem der vorhergehenden Ansprüche,
**dadurch gekennzeichnet, dass**
die Magneteinrichtung (28) Magneteinheiten aufweist, die an einer Basis (34) der ersten Magnetkerneinrichtung (24) zwischen den Zinken (38) angeordnet sind.

7. Leiterplattenvorrichtung (10) nach einem der vorhergehenden Ansprüche,
**dadurch gekennzeichnet, dass**
die Spuleneinrichtung (30) Spuleneinheiten aufweist, wobei eine jeweilige der Spuleneinheiten aus Kupferbahnen gegenüberliegender Seiten der zweiten Leiterplatteneinrichtung (14) und Durchkontaktierungen durch die zweite Leiterplatteneinrichtung (14) bereitgestellt ist.

8. Leiterplattenvorrichtung (10) nach einem der vorhergehenden Ansprüche,
**dadurch gekennzeichnet, dass**
die Spuleneinrichtung (30) Spulen aufweist, die an einer Basis (34) der zweiten Magnetkerneinrichtung (26) zwischen den Zinken (40) angeordnet sind.

9. Leiterplattenvorrichtung (10) nach einem der vorhergehenden Ansprüche,
**dadurch gekennzeichnet, dass**
die Spuleneinrichtung (30) Spulen aufweist, entlang der Zinken (40) angeordnet sind.

10. Leiterplattenvorrichtung (10) nach einem der vorhergehenden Ansprüche,
**dadurch gekennzeichnet, dass**
die Federeinrichtung (18) als Balkenstruktur in der Leiterplattenvorrichtung (10) eingerichtet ist.

11. Leiterplattenvorrichtung (10) nach Anspruch 1,
**dadurch gekennzeichnet, dass**
- die Magnetkerneinrichtungen (24, 26) eine jeweilige Klauenpolstruktur mit zwei Basisflächen (60) aufweist,
- eine jeweilige Basisfläche (60) jeweilige Klauen (62) aufweist, die entlang einer Klauenkante (64) senkrecht zur Basisfläche (60) angeordnet und durch Nuten (42) voneinander beabstandet sind,
- die zwei Basisflächen (60) parallel zueinander angeordnet sind, wobei die Klauen (62) entlang der Klauenkante (64) alternierend zueinander angeordnet sind,
- die Klauenpolstrukturen der Magnetkerneinrichtung (24, 26) entlang der Klauenkanten (64) gegenüberliegend angeordnet sind, wobei eine Klaue (62) der ersten Klauenpolstruktur gegenüber einer Klaue (62) der zweiten Klauenpolstruktur angeordnet und durch den Trennspalt (16) getrennt ist, und
- durch eine Auslenkung der Leiterplatteneinrichtung (12) die Klauen (62) gegeneinander verschoben werden, sodass ein Überdeckungsbereich der gegenüberliegenden Klauen (62) entlang des Trennspalts (16) variiert, wodurch der Hauptmagnetfluss (32) durch die Spuleneinrichtung (30) in Abhängigkeit von der Auslenkung verändert wird.

12. Leiterplattenvorrichtung (10) nach Anspruch 11,
**dadurch gekennzeichnet dass**
die Magnetkerneinrichtungen (24, 26) derart eingerichtet sind, dass ab einem bestimmten Verschiebeweg entlang der Hauptrichtung (20) eine Klaue (60) einer der Magnetkerneinrichtungen (24, 26) gegenüber einer direkt benachbarten Klaue (60) der anderen Magnetkerneinrichtung (24, 26) angeordnet ist, sodass der Hauptmagnetfluss (32) durch die Spuleneinrichtung (30) umgedreht wird.

13. Vorrichtung, aufweisend eine Leiterplattenvorrichtung (10) nach einem der vorhergehenden Ansprüche.
